# EUROPEAN PATENT SPECIFICATION

(11) **EP 4 016 843 B1**
(45) Date of publication and mention of the grant of the patent: **08.11.2023**
(21) Application number: 20896816.4
(22) Date of filing: 02.12.2020
(51) Int. Cl.: H03K 5/1252, H03K 5/151, H03K 19/0185

(54) **SIGNAL SHAPING CIRCUIT AND CORRESPONDING GATE DRIVING CIRCUIT**
SIGNALFORMERSCHALTUNG UND ENTSPRECHENDE GATE-TREIBERSCHALTUNG
CIRCUIT DE MISE EN FORME DE SIGNAL ET CIRCUIT D'ATTAQUE DE GRILLE CORRESPONDANT

(30) Priority: 02.12.2019 CN 201911212023
(43) Date of publication of application: 22.06.2022
(73) Proprietor: CRM ICBG (WUXI) CO., LTD., Wuxi, Jiangsu 214135 (CN)
(72) Inventor: LIU, Weizhong, Wuxi, Jiangsu 214135 (CN); ZHANG, Mingfeng, Wuxi, Jiangsu 214135 (CN); SHEN, Chao, Wuxi, Jiangsu 214135 (CN); JIANG, Yaping, Wuxi, Jiangsu 214135 (CN); NIU, Ruiping, Wuxi, Jiangsu 214135 (CN)
(74) Representative: Canzler & Bergmeier Patentanwälte Partnerschaft mbB
(86) International application number: PCT/CN2020/133350
(87) International publication number: WO 2021/110043

(56) References cited:
- EP-A1- 2 592 381
- CN-A- 101 917 811
- CN-A- 102 611 425
- CN-B- 102 647 177
- CN-U- 208 079 042
- US-A- 5 652 528
- US-A1- 2010 277 206
- US-A1- 2018 269 858
- US-A1- 2019 103 859

## Description

### Cross Reference to Related Application

This application claims priority to Chinese Patent Application No. 201911212023.8, filed with the China National Intellectual Property Administration on December 2, 2019 and entitled "SIGNAL SHAPING CIRCUIT AND CORRESPONDING GATE DRIVING CIRCUIT".

### Technical Field

The present disclosure relates to the field of electricity, and in particular, to the field of circuit anti-interference technologies, and specifically refers to a signal shaping circuit and a corresponding gate driving circuit.

### Background

In some control circuits, due to the deviation of an actual manufacturing process, there is a mismatch between two level shift circuits, and noise caused by an amplitude difference in output signals of the level shift circuits is called offset noise here. The offset noise may also be transmitted as an input signal by a subsequent-stage circuit, which may lead to a system failure due to an error state. In a traditional circuit structure, the difference signal cannot be identified and eliminated.

For example, in the application field of high-voltage such as power electronics, control circuits in the form of integrated circuits have gradually replaced conventional control systems built by separate devices. High-voltage and low-voltage control circuits, various devices with protection functions, high-voltage power devices and other devices are integrated through packaging integration or process integration, to greatly improve the integration and reliability of the whole system.

In such applications, the control circuit is very important. Such a circuit that integrates high and low voltages is often called a half-bridge driving circuit, which is mainly used to drive a power transistor of an external half-bridge topology. In the half-bridge driving circuit, due to features such as a simple structure, low cost, and high cost-effectiveness, a bootstrap capacitive structure is more convenient and more widely used.

To reduce power loss of a circuit, in the bootstrap capacitive half-bridge driving circuit, an electrical signal of a high-voltage-side control circuit is mainly generated by dual short pulse circuits, and then on/off pulses are converted into normal control signals for a power transistor through an RS flip-flop. Because the high-voltage-side circuit uses a floating power supply, during fast switching, in a process of charging and discharging a parasitic capacitor, a displacement current is generated in a high-voltage level conversion circuit, and a voltage drop is formed on a resistor of a high-voltage side, that is, common mode noise. The voltage signal easily triggers a subsequent-stage circuit, leading to circuit damage or burnout due to an error state. In response, generally, a pulse filter circuit is used to eliminate the noise. For example, Fairchild Semiconductor generally uses an analog filter circuit to filter out noise signals, and other companies such as Mitsubishi use digital filters to filter out noise.

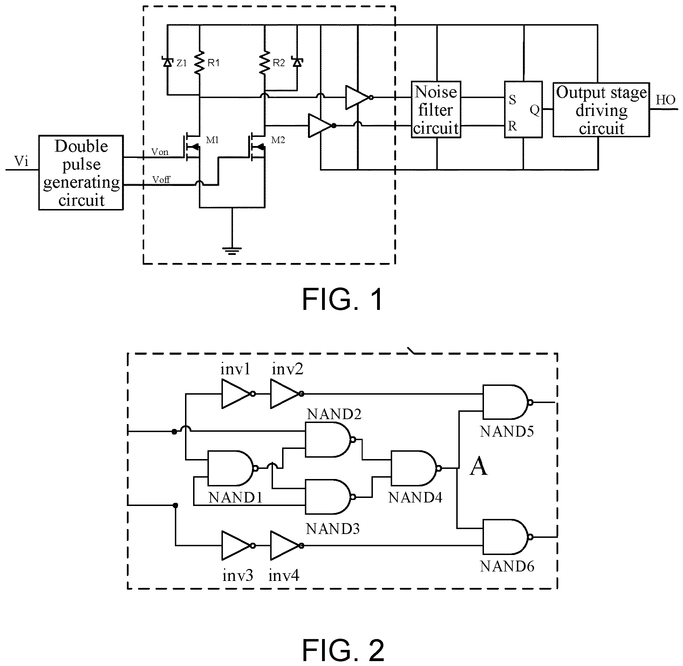

No matter which method is used, a certain effect of eliminating the common mode noise is achieved. Fig. 1 shows an anti-noise high-side driving circuit in the related art, which includes a double-pulse generating circuit, a noise filter circuit, an RS flip-flop, and an output driving circuit. Fig. 2 is a circuit diagram of the noise filter circuit in the anti-noise high-side driving circuit in Fig. 1.

In actual circuit implementation, to more effectively filter out noise, devices are generally matched as much as possible in the design to make internal noise features consistent and make the noise easier to be filtered out. However, process deviations still exist in actual manufacturing, resulting in offset noise in a circuit. Although the anti-noise high-side driving circuit in Fig. 1 and Fig. 2 uses an exclusive OR function structure to eliminate common mode noise, offset noise cannot be suppressed and may still be transferred to the subsequent stage, thereby affecting the accuracy of circuit control.

The document EP 2 592 381 A1 discloses a set/reset signal generation circuit comprising two complementary common source paths including RC filtering.

### Summary

The objective of the present disclosure is to overcome at least one of the above-mentioned shortcomings of the related art, and provide a signal shaping circuit with good anti-interference effect and stable performance and a corresponding gate driving circuit.

To achieve the above-mentioned or other objectives, the signal shaping circuit and the corresponding gate driving circuit of the present invention are as follows:

The signal shaping circuit includes a turn-on signal shaping module and a turn-off signal shaping module,
where the turn-on signal shaping module includes a first PMOS transistor, a first NMOS transistor, a second NMOS transistor, a first resistor, a second resistor, a first capacitor, and a first inverter;
a gate of the first PMOS transistor is connected with a first input signal, a drain of the first PMOS transistor is respectively connected with a first end of the first resistor, a first end of the first capacitor, and a gate of the second NMOS transistor, and a source of the first PMOS transistor is connected with a source of the first NMOS transistor;
a gate of the first NMOS transistor is connected with a second input signal, and a drain of the first NMOS transistor and a first end of the second resistor are both connected with a reference voltage;
a drain of the second NMOS transistor is connected with a second end of the second resistor, and a source of the second NMOS transistor, a second end of the first resistor, and a second end of the first capacitor are all grounded;
an input end of the first inverter is connected with the second end of the second resistor, a voltage end of the first inverter is connected with the reference voltage, a ground end of the first inverter is grounded, and an output end of the first inverter constitutes a first output end of the signal shaping circuit;
the turn-off signal shaping module includes a second PMOS transistor, a third NMOS transistor, a fourth NMOS transistor, a third resistor, a fourth resistor, a second capacitor, and a second inverter;
a gate of the second PMOS transistor is connected with the second input signal, a drain of the second PMOS transistor is respectively connected with a first end of the third resistor, a first end of the second capacitor, and a gate of the fourth NMOS transistor, and a source of the second PMOS transistor is connected with a source of the third NMOS transistor;
a gate of the third NMOS transistor is connected with the first input signal, and a drain of the third NMOS transistor and a first end of the fourth resistor are both connected with the reference voltage;
a drain of the fourth NMOS transistor is connected with a second end of the fourth resistor, and a source of the fourth NMOS transistor, a second end of the third resistor, and a second end of the second capacitor are all grounded; and
an input end of the second inverter is connected with the second end of the fourth resistor, a voltage end of the second inverter is connected with the reference voltage, a ground end of the second inverter is grounded, and an output end of the second inverter constitutes a second output end of the signal shaping circuit.

Preferably, the turn-on signal shaping module further includes a third PMOS transistor, a fifth NMOS transistor, a sixth NMOS transistor, and a fifth resistor;
a gate of the third PMOS transistor is connected with the second input signal, and a drain of the third PMOS transistor is respectively connected with a drain and a gate of the fifth NMOS transistor and a gate of the sixth NMOS transistor; a source of the third PMOS transistor is connected with the reference voltage through the fifth resistor;
a source of the fifth NMOS transistor and a source of the sixth NMOS transistor are both grounded;
a drain of the sixth NMOS transistor is connected with a drain of the first PMOS transistor;
the turn-off signal shaping module further includes a fourth PMOS transistor, a seventh NMOS transistor, an eighth NMOS transistor, and a sixth resistor;
a gate of the fourth PMOS transistor is connected with the first input signal, and a drain of the fourth PMOS transistor is respectively connected with a drain and a gate of the seventh NMOS transistor and a gate of the eighth NMOS transistor; a source of the fourth PMOS transistor is connected with the reference voltage through the sixth resistor;
a source of the seventh NMOS transistor and a source of the eighth NMOS transistor are both grounded; and
a drain of the eighth NMOS transistor is connected with a drain of the second PMOS transistor.

A gate driving circuit with the signal shaping circuit is provided, where the gate driving circuit further includes:
a pulse generating circuit, configured to generate a pulse-on signal and a pulse-off signal according to an input signal;
a level shift circuit, configured to convert the pulse-on signal and the pulse-off signal into the first input signal and the second input signal sent to the signal shaping circuit;
a noise filter circuit, configured to further eliminate short-pulse noise in a signal outputted by the signal shaping circuit; and
an output stage driving circuit connected with the noise filter circuit.

Preferably, the level shift circuit includes a ninth NMOS transistor and a tenth NMOS transistor,
where a gate of the ninth NMOS transistor is connected with the turn-on pulse signal, a source of the ninth NMOS transistor is grounded, and a drain of the ninth NMOS transistor is connected with the reference voltage through a seventh resistor;
a drain of the ninth NMOS transistor is further served as a first output end of the level shift circuit to output the first input signal;
a gate of the tenth NMOS transistor is connected with the pulse-off signal, a source of the tenth NMOS transistor is grounded, and a drain of the tenth NMOS transistor is connected with the reference voltage through an eighth resistor; and
a drain of the tenth NMOS transistor is further served as a second output end of the level shift circuit to output the second input signal.

Preferably, the level shift circuit further includes a first Zener diode and a second Zener diode;
an anode of the first Zener diode is connected with a drain of the ninth NMOS transistor, and a cathode of the first Zener diode is connected with the reference voltage; and
an anode of the second Zener diode is connected with a drain of the tenth NMOS transistor, and a cathode of the second Zener diode is connected with the reference voltage.

Preferably, the noise filter circuit includes a first inverter chain, a ninth resistor, a third capacitor, a first Schmitt trigger, a second inverter chain, a tenth resistor, a fourth capacitor, and a second Schmitt trigger;
an input end of the first inverter chain is connected with the first output end of the signal shaping circuit, an output end of the first inverter chain is connected with a first end of the ninth resistor, a second end of the ninth resistor is respectively connected with a first end of the third capacitor and an input end of the first Schmitt trigger, a second end of the third capacitor is grounded, and an output end of the first Schmitt trigger constitutes a first output end of the noise filter circuit, and is connected with a first input end of the output stage driving circuit;
an input end of the second inverter chain is connected with the second output end of the signal shaping circuit, an output end of the second inverter chain is connected with a first end of the tenth resistor, a second end of the tenth resistor is respectively connected with a first end of the fourth capacitor and an input end of the second Schmitt trigger, a second end of the fourth capacitor is grounded, and an output end of the second Schmitt trigger constitutes a second output end of the noise filter circuit, and is connected with a second input end of the output stage driving circuit;
power supply ends of the first inverter chain, the second inverter and the first Schmitt trigger are all connected with the reference voltage; and
ground ends of the first inverter chain, the second inverter and the first Schmitt trigger are all grounded.

Preferably, the output stage driving circuit includes a first NAND gate, a third inverter chain, a fifth PMOS transistor, an eleventh resistor, a second NAND gate, a fourth inverter chain, an eleventh NMOS transistor, and a twelfth resistor;
a first end of the first NAND gate constitutes a first input end of the output stage driving circuit, an output end of the first NAND gate is respectively connected with an input end of the third inverter chain and a second end of the second NAND gate, an output end of the third inverter chain is connected with a gate of the fifth PMOS transistor, a source of the fifth PMOS transistor is connected with the reference voltage, and a drain of the fifth PMOS transistor is connected with a first end of the eleventh resistor;
a first end of the second NAND gate constitutes a second input end of the output stage driving circuit, an output end of the second NAND gate is respectively connected with an input end of the fourth inverter chain and a second end of the first NAND gate, an output end of the fourth inverter chain is connected with a gate of the eleventh NMOS transistor, a source of the eleventh NMOS transistor is grounded, and a drain of the eleventh NMOS transistor is connected with a first end of the twelfth resistor;
a second end of the eleventh resistor and a second end of the twelfth resistor together constitute an output end of the output stage driving circuit;
power supply ends of the first NAND gate, the third inverter chain, the second NAND gate, and the fourth inverter chain are all connected with the reference voltage; and
ground ends of the first NAND gate, the third inverter chain, the second NAND gate, and the fourth inverter chain are all grounded.

Preferably, the output stage driving circuit includes a third NAND gate, a fourth NAND gate, a fifth inverter chain, a sixth inverter chain, a twelfth NMOS transistor, a thirteenth NMOS transistor, and a fourteenth NMOS transistor, a fifteenth NMOS transistor, a sixth PMOS transistor, a seventh PMOS transistor, an eighth PMOS transistor, and a ninth PMOS transistor;
a first end of the third NAND gate constitutes a first input end of the output stage driving circuit, and an output end of the third NAND gate is respectively connected with an input end of the fifth inverter chain and a second end of the fourth NAND gate;
a first end of the fourth NAND gate constitutes a second input end of the output stage driving circuit, and an output end of the fourth NAND gate is connected with a second end of the third NAND gate;
an output end of the fifth inverter chain is respectively connected with an input end of the sixth inverter chain, a gate of the seventh PMOS transistor, and a gate of the fourteenth NMOS transistor;
an output end of the sixth inverter chain is respectively connected with a drain of the twelfth NMOS transistor, a gate of the thirteenth NMOS transistor, a drain of the sixth PMOS transistor, and a gate of the eighth PMOS transistor;
a drain of the seventh PMOS transistor is respectively connected with a drain of the thirteenth NMOS transistor, a gate of the ninth PMOS transistor, and a gate of the sixth PMOS transistor;
a drain of the fourteenth NMOS transistor is respectively connected with a drain of the eighth PMOS transistor, a gate of the fifteenth NMOS transistor, and a gate of the twelfth NMOS transistor;
a source of the seventh PMOS transistor, a source of the eighth PMOS transistor, and a source of the ninth PMOS transistor are all connected with the reference voltage;
a source of the twelfth NMOS transistor, a source of the thirteenth NMOS transistor, a source of the fourteenth NMOS transistor, and a source of the fifteenth NMOS transistor are all grounded;
a drain of the ninth PMOS transistor and a drain of the fifteenth NMOS transistor together constitute an output end of the output stage driving circuit;
power supply ends of the third NAND gate, the fourth NAND gate, the fifth inverter chain, and the sixth inverter chain are all connected with the reference voltage; and
ground ends of the third NAND gate, the fourth NAND gate, the fifth inverter chain and the sixth inverter chain are all grounded.

An additional NMOS transistor is added to the signal shaping circuit, which improves requirements for the amplitude of an input differential signal. By setting parallel resistors and capacitors in the circuit, the amplitude of the input differential signal needs to be higher than a certain value for a certain period of time before being recognized as a trigger signal, and some interference or offset noise caused by device mismatch is effectively filtered out. A gate driving circuit using the signal shaping circuit further includes a pulse generating circuit, a level shift circuit, a noise filter circuit and an output stage driving circuit, and the offset noise and common mode noise can be effectively filtered out through the cooperation of the circuits. By using the signal shaping circuit and the corresponding gate driving circuit of the present disclosure, a circuit works more reliably and the performance is more stable.

### Brief Description of the Drawings

Fig. 1 is a schematic diagram of an anti-noise high-side driving circuit in the related art;
Fig. 2 is a circuit diagram of a noise filter circuit in the anti-noise high-side driving circuit in Fig. 1;
Fig. 3 is a schematic structural diagram of a signal shaping circuit according to an embodiment of the present disclosure;
Fig. 4 is a schematic structural diagram of a signal shaping circuit according to another embodiment of the present disclosure;
Fig. 5 is a schematic diagram of a gate driving circuit according to an embodiment of the present disclosure;
Fig. 6 is a schematic structural diagram of a noise filter circuit and an output stage driving circuit in a gate driving circuit according to an embodiment of the present disclosure; and
Fig. 7 is a schematic structural diagram of an output stage driving circuit in a gate driving circuit according to an embodiment of the present disclosure.

### Detailed Description of the Preferred Embodiments

To make the objectives, technical solutions, and advantages of the present disclosure clearer, the following further describes the present disclosure in detail with reference to specific embodiments.

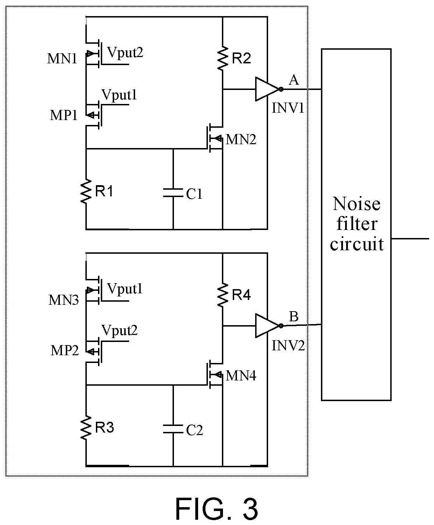

As shown in FIG. 3, in an embodiment, a signal shaping circuit of the present disclosure includes a turn-on signal shaping module and a turn-off signal shaping module.

The turn-on signal shaping module includes a first PMOS transistor MP1, a first NMOS transistor MN1, a second NMOS transistor MN2, a first resistor R1, a second resistor R2, a first capacitor C1, and a first inverter INV1.

A gate of the first PMOS transistor MP1 is connected with a first input signal Vput1, a drain of the first PMOS transistor MP1 is respectively connected with a first end of the first resistor R1, a first end of the first capacitor C1, and a gate of the second NMOS transistor MN2, and a source of the first PMOS transistor MP1 is connected with a source of the first NMOS transistor MN1.

A gate of the first NMOS transistor MN1 is connected with a second input signal Vput2, and a drain of the first NMOS transistor MN1 and a first end of the second resistor R2 are both connected with a reference voltage VB.

A drain of the second NMOS transistor MN2 is connected with a second end of the second resistor R2, and a source of the second NMOS transistor MN2, a second end of the first resistor R1, and a second end of the first capacitor C1 are all grounded.

An input end of the first inverter INV1 is connected with a second end of the second resistor R2, a voltage end of the first inverter INV1 is connected with the reference voltage VB, a ground end of the first inverter INV1 is grounded, and an output end of the first inverter INV1 constitutes a first output end of the signal shaping circuit.

The turn-off signal shaping module includes a second PMOS transistor MP2, a third NMOS transistor MN3, a fourth NMOS transistor MN4, a third resistor R3, a fourth resistor R4, a second capacitor C2, and a second inverter INV2.

A gate of the second PMOS transistor MP2 is connected with the second input signal Vput2, a drain of the second PMOS transistor MP2 is respectively connected with a first end of the third resistor R3, a first end of the second capacitor C2, and a gate of the fourth NMOS transistor MN4, and a source of the second PMOS transistor MP2 is connected with a source of the third NMOS transistor MN3.

A gate of the third NMOS transistor MN3 is connected with the first input signal Vput1, and a drain of the third NMOS transistor MN3 and a first end of the fourth resistor R4 are both connected with the reference voltage VB.

A drain of the fourth NMOS transistor MN4 is connected with a second end of the fourth resistor R4, and a source of the fourth NMOS transistor MN4, a second end of the third resistor R3, and a second end of the second capacitor C2 are all grounded.

An input end of the second inverter INV2 is connected with a second end of the fourth resistor R4, a voltage end of the second inverter INV2 is connected with the reference voltage VB, a ground end of the second inverter INV2 is grounded, and an output end of the second inverter INV2 constitutes a second output end of the signal shaping circuit.

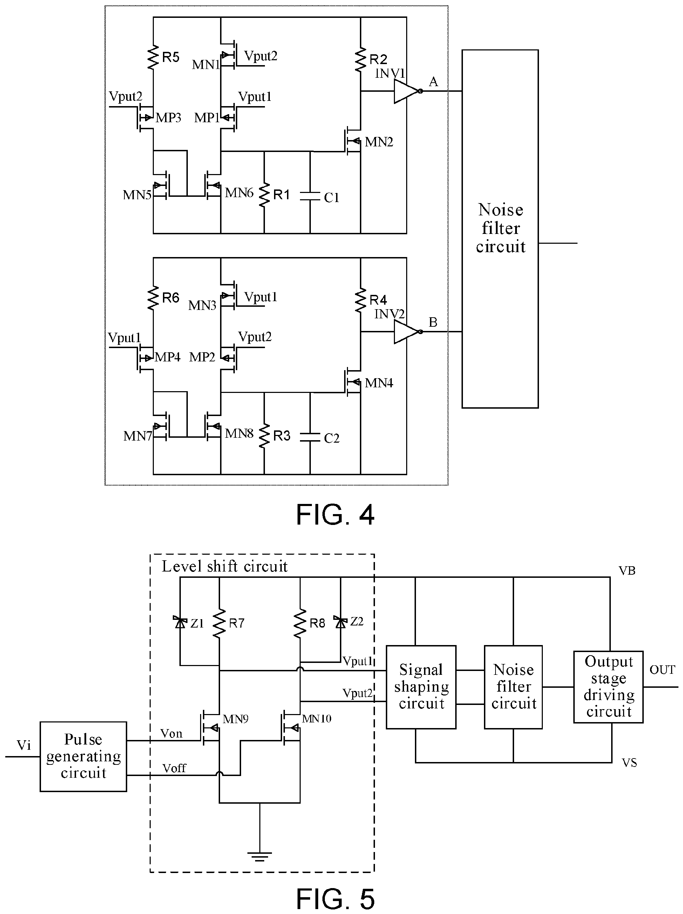

As shown in Fig. 4, in another embodiment, a signal shaping circuit of the present disclosure, based on the circuit in Fig. 3, is further provided with a third PMOS transistor MP3, a fifth NMOS transistor MN5, a sixth NMOS transistor MN6, and a fifth resistor R5 in the turn-on signal shaping module.

A gate of the third PMOS transistor MP3 is connected with the second input signal Vput2, and a drain of the third PMOS transistor MP3 is respectively connected with a drain and a gate of the fifth NMOS transistor MN5 and a gate of the sixth NMOS transistor MN6; a source of the third PMOS transistor MP3 is connected with the reference voltage VB through the fifth resistor R5.

A source of the fifth NMOS transistor MN5 and a source of the sixth NMOS transistor MN6 are both grounded.

A drain of the sixth NMOS transistor MN6 is connected with a drain of the first PMOS transistor MP1.

The turn-off signal shaping module is further provided with a fourth PMOS transistor MP4, a seventh NMOS transistor MN7, an eighth NMOS transistor MN8, and a sixth resistor R6.

A gate of the fourth PMOS transistor MP4 is connected with the first input signal Vput1, and a drain of the fourth PMOS transistor MP4 is respectively connected with a drain and a gate of the seventh NMOS transistor MN7 and a gate of the eighth NMOS transistor MN8; a source of the fourth PMOS transistor MP4 is connected with the reference voltage VB through the sixth resistor R6.

A source of the seventh NMOS transistor MN7 and a source of the eighth NMOS transistor MN8 are both grounded.

A drain of the eighth NMOS transistor MN8 is connected with a drain of the second PMOS transistor MP2.

Performance of the signal shaping circuit in the embodiment of Fig. 4 is better than the signal shaping circuit in the embodiment of Fig. 3. The circuit in Fig. 3 can also output corresponding signals according to the first input signal Vput1 and the second input signal Vput2 to achieve the effect of eliminating offset noise. However, because the circuit in Fig. 3 can only provide a pull-down function through the first resistor R1 and the third resistor R3, the pull-down capability is weak, and anti-interference performance is not as good as the signal shaping circuit in the embodiment in Fig. 4.

A working principle of the signal shaping circuit is described below with reference to the upper part of the circuit in Fig. 4.

It can be seen from Fig. 4 that, the upper part of the circuit, that is, the turn-on signal shaping module, includes a first PMOS transistor MP1, a first NMOS transistor MN1, a second NMOS transistor MN2, a first resistor R1, a second resistor R2, a first capacitor C1, a first inverter INV1, a third PMOS transistor MP3, a fifth NMOS transistor MN5, a sixth NMOS transistor MN6, and a fifth resistor R5. The first PMOS transistor MP1, the first NMOS transistor MN1, the third PMOS transistor MP3, the fifth NMOS transistor MN5, and the sixth NMOS transistor MN6 form a signal input stage structure. The fifth NMOS transistor MN5 and the sixth NMOS transistor MN6 form a current mirror. The first PMOS transistor MP1 and the third PMOS transistor MP3 form a differential pair input structure. As shown in Fig. 4, one first NMOS transistor MN1 is connected in series to the first PMOS transistor MP1, and the same input signal is connected with gates of the first NMOS transistor MN1 and the third PMOS transistor MP3.

If there is no first NMOS transistor MN1 in the circuit, when the first input signal Vput1 and the second input signal Vput2 are inputted to form a differential signal, the first input signal Vput1 and the second input signal Vput2 are easily recognized and transmitted to a second stage to generate an output signal. If the first NMOS transistor MN1 is added to the circuit, the first PMOS transistor MP1 and the first NMOS transistor MN1 are turned on at the same time only when a difference between the first input signal Vput1 and the second input signal Vput2 needs to at least exceed a sum of thresholds of the first PMOS transistor MP1 and the first NMOS transistor MN1 (assuming that the threshold of the first NMOS transistor MN1 is Vthn1, thresholds of the first PMOS transistor MP1 and the third PMOS transistor MP3 are both Vthp1, then a sum of the thresholds of the first PMOS transistor MP1 and the first NMOS transistor MN1 is Vthn1 + Vthp1). The circuit is further provided with a first resistor R1 and a first capacitor C1. Therefore, an amplitude of a differential signal inputted to the circuit needs to be higher than the sum of the thresholds of the first PMOS transistor MP1 and the first NMOS transistor MN1 for a certain period of time to generate a second-stage input signal. As a result, some interference or offset noise caused by device mismatch can be effectively filtered out.

Because a structure and a working principle of the turn-off signal shaping module are similar to those of the turn-on signal shaping module, details are not repeated herein.

A first output end and a second output end of the signal shaping circuit in Fig. 3 and Fig. 4 are both connected with a post-stage noise filter circuit. In other embodiments, the above-mentioned signal shaping circuit can also be applied to other situations, and is connected with a corresponding circuit of a subsequent stage.

As shown in Fig. 5, a gate driving circuit including the above-mentioned signal shaping circuit further includes:
a pulse generating circuit, configured to generate a pulse-on signal Von and a pulse-off signal Voff according to an input signal Vi, where the pulse generating circuit is a double pulse generating circuit, where the pulse-on signal Von and the pulse-off signal Voff are respectively generated on a rising edge or a falling edge of the input signal Vi;
a level shift circuit, configured to convert the pulse-on signal Von and the pulse-off signal Voff into the first input signal Vput1 and the second input signal Vput2 sent to the signal shaping circuit, that is, transfer the pulse-on signal Von and the pulse-off signal Voff to a high-level circuit side to be converted into a first input signal Vput1 and a second input signal Vput2.

In this embodiment, the level shift circuit includes a ninth NMOS transistor MN9 and a tenth NMOS transistor MN10, and the ninth NMOS transistor MN9 and the tenth NMOS transistor MN10 are two high-voltage NMOS transistors. A gate of the ninth NMOS transistor MN9 is connected with the pulse-on signal Von, a source of the ninth NMOS transistor MN9 is grounded, and a drain of the ninth NMOS transistor MN9 is respectively connected with a first end of the seventh resistor R7 and an anode of the first Zener diode Z1. A second end of the seventh resistor R7 and a cathode of the first Zener diode Z1 are both connected with the reference voltage VB.

A drain of the ninth NMOS transistor MN9 is further served as a first output end of the level shift circuit to output the first input signal Vput1.

A gate of the tenth NMOS transistor MN10 is connected with the pulse-off signal Voff, a source of the tenth NMOS transistor MN10 is grounded, and a drain of the tenth NMOS transistor MN10 is respectively connected with a first end of the eighth resistor R8 and an anode of the second Zener diode Z2. A second end of the eighth resistor R8 and a cathode of the second Zener diode Z2 are both connected with the reference voltage VB.

A drain of the tenth NMOS transistor MN10 is further served as a second output end of the level shift circuit to output the second input signal Vput2.

A working principle of the level shift circuit is as follows:
When the ninth NMOS transistor MN9 is turned on, a pull-down current is generated to pass through the seventh resistor R7, and a voltage signal relative to the reference voltage VB, namely, the first input signal Vput1, is generated. When the tenth NMOS transistor MN10 is turned on, a pull-down current is generated to pass through the eighth resistor R8, and a voltage signal relative to the reference voltage VB, namely, the second input signal Vput2, is generated. The first Zener diode Z1 and the second Zener diode Z2 are used for clamping to prevent the first input signal Vput1 and the second input signal Vput2 from falling too much relative to the reference voltage VB, thus avoiding damage to the circuit.

A noise filter circuit is configured to further eliminate short-pulse noise in a signal outputted by the signal shaping circuit.

In this embodiment, the noise filter circuit includes a first inverter chain, a ninth resistor R9, a third capacitor C3, a first Schmitt trigger SIMT1, a second inverter chain, a tenth resistor R10, a fourth capacitor C4, and a second Schmitt trigger SIMT2.

An input end of the first inverter chain is connected with a first output end of the signal shaping circuit. An output end of the first inverter chain is connected with a first end of the ninth resistor R9. A second end of the ninth resistor R9 is respectively connected with a first end of the third capacitor C3 and an input end of the first Schmitt trigger SIMT1. A second end of the third capacitor C3 is grounded. An output end of the first Schmitt trigger SIMT1 constitutes a first output end of the noise filter circuit, and is connected with a first input end of the output stage driving circuit.

An input end of the second inverter chain is connected with a second output end of the signal shaping circuit. An output end of the second inverter chain is connected with a first end of the tenth resistor R10. A second end of the tenth resistor R10 is respectively connected with a first end of the fourth capacitor C4 and an input end of the second Schmitt trigger SIMT2. A second end of the fourth capacitor C4 is grounded. An output end of the second Schmitt trigger SIMT2 constitutes a second output end of the noise filter circuit, and is connected with a second input end of the output stage driving circuit.

Power supply ends of the first inverter chain, the second inverter and the first Schmitt trigger SIMT1 are all connected with the reference voltage VB.

Ground ends of the first inverter chain, the second inverter and the first Schmitt trigger SIMT1 are all grounded.

In the noise filter circuit in this embodiment, the ninth resistor R9 and the third capacitor C3 (the tenth resistor R10 and the fourth capacitor C4) form a filter circuit to further filter a signal outputted by a previous-stage signal shaping circuit to eliminate a short-pulse noise signal.

The output stage driving circuit is connected with the noise filter circuit and outputs a gate driving signal OUT.

In this embodiment, the output stage driving circuit includes a first NAND gate NAND1, a third inverter chain, a fifth PMOS transistor MP5, an eleventh resistor R11, a second NAND gate NAND2, a fourth inverter chain, an eleventh NMOS transistor MN11, and a twelfth resistor R12.

A first end of the first NAND gate NAND1 constitutes a first input end of the output stage driving circuit. An output end of the first NAND gate NAND1 is respectively connected with an input end of the third inverter chain and a second end of the second NAND gate NAND2. An output end of the third inverter chain is connected with a gate of the fifth PMOS transistor MP5. A source of the fifth PMOS transistor MP5 is connected with the reference voltage VB, and a drain of the fifth PMOS transistor MP5 is connected with a first end of the eleventh resistor R11.

A first end of the second NAND gate NAND2 constitutes a second input end of the output stage driving circuit. An output end of the second NAND gate NAND2 is respectively connected with an input end of the fourth inverter chain and a second end of the first NAND gate NAND1. An output end of the fourth inverter chain is connected with a gate of the eleventh NMOS transistor MN11. A source of the eleventh NMOS transistor MN11 is grounded, and a drain of the eleventh NMOS transistor MN11 is connected with a first end of the twelfth resistor R12.

A second end of the eleventh resistor R11 and a second end of the twelfth resistor R12 together constitute an output end of the output stage driving circuit.

Power supply ends of the first NAND gate NAND1, the third inverter chain, the second NAND gate NAND2, and the fourth inverter chain are all connected with the reference voltage VB.

Ground ends of the first NAND gate NAND1, the third inverter chain, the second NAND gate NAND2, and the fourth inverter chain are all grounded.

In this circuit, an RS flip-flop formed by the first NAND gate NAND1 and the second NAND gate NAND2 can effectively lock and save an effective pulse input signal. A final gate driving signal OUT is generated after the pulse input signal passes through the fifth PMOS transistor, the eleventh NMOS transistor, the eleventh resistor R11, and the twelfth resistor R12 in the subsequent stage.

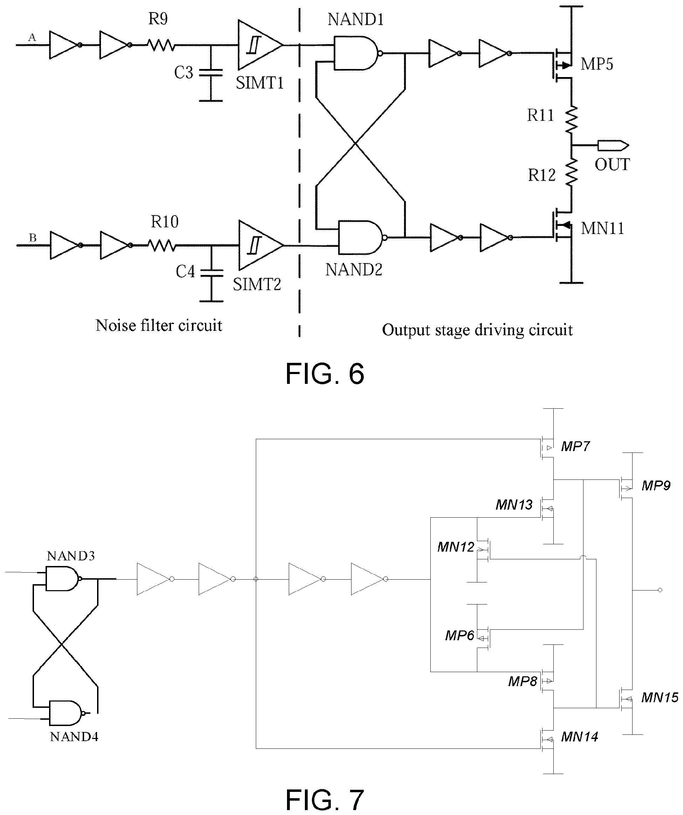

Refer to Fig. 6 for structures of the noise filter circuit and the output stage driving circuit in this embodiment, where the first inverter chain, the second inverter chain, the third inverter chain, and the fourth inverter chain can all include cascaded inverters. End A and end B in the noise filter circuit in FIG. 6 are respectively connected with end A and end B in Fig. 3 or Fig. 4.

In another embodiment, the output stage driving circuit can also be implemented by a circuit groove shown in FIG. 7, which includes a third NAND gate NAND3, a fourth NAND gate NAND4, a fifth inverter chain, a sixth inverter chain, a twelfth NMOS transistor MN12, a thirteenth NMOS transistor MN13, and a fourteenth NMOS transistor MN14, a fifteenth NMOS transistor MN15, a sixth PMOS transistor MP6, a seventh PMOS transistor MP7, an eighth PMOS transistor MP8, and a ninth PMOS transistor MP9.

Afirst end of the third NAND gate NAND3 constitutes a first input end of the output stage driving circuit. An output end of the third NAND gate NAND3 is respectively connected with an input end of the fifth inverter chain and a second end of the fourth NAND gate NAND4.

Afirst end of the fourth NAND gate NAND4 constitutes a second input end of the output stage driving circuit, and an output end of the fourth NAND gate NAND4 is connected with a second end of the third NAND gate NAND3.

An output end of the fifth inverter chain is respectively connected with an input end of the sixth inverter chain, a gate of the seventh PMOS transistor MP7, and a gate of the fourteenth NMOS transistor MN14.

An output end of the sixth inverter chain is respectively connected with a drain of the twelfth NMOS transistor MN12, a gate of the thirteenth NMOS transistor MN13, a drain of the sixth PMOS transistor MP6, and a gate of the eighth PMOS transistor MP8.

A drain of the seventh PMOS transistor MP7 is respectively connected with a drain of the thirteenth NMOS transistor MN13, a gate of the ninth PMOS transistor MP9, and a gate of the sixth PMOS transistor MP6.

A drain of the fourteenth NMOS transistor MN14 is respectively connected with a drain of the eighth PMOS transistor MP8, a gate of the fifteenth NMOS transistor MN15, and a gate of the twelfth NMOS transistor MN12.

A source of the seventh PMOS transistor MP7, a source of the eighth PMOS transistor MP8, and a source of the ninth PMOS transistor MP9 are all connected with the reference voltage VB.

A source of the twelfth NMOS transistor MN12, a source of the thirteenth NMOS transistor MN13, a source of the fourteenth NMOS transistor MN14, and a source of the fifteenth NMOS transistor MN15 are all grounded.

A drain of the ninth PMOS transistor MP9 and a drain of the fifteenth NMOS transistor MN15 together constitute an output end of the output stage driving circuit.

Power supply ends of the third NAND gate NAND3, the fourth NAND gate NAND4, the fifth inverter chain, and the sixth inverter chain are all connected with the reference voltage VB.

Ground ends of the third NAND gate NAND3, the fourth NAND gate NAND4, the fifth inverter chain and the sixth inverter chain are all grounded.

The fifth inverter chain and the sixth inverter chain may include cascaded inverters.

The output stage driving circuit in this embodiment respectively controls the ninth PMOS transistor MP9 and the fifteenth NMOS transistor MN15, which can prevent a passing-through current from damaging an output stage circuit, uses a two-stage inverter chain (the fifth inverter chain and the sixth inverter chain) to produce an extremely short dead time, and achieves a clamping effect through the sixth PMOS transistor MP6 and the twelfth NMOS transistor MN12 to avoid device damage caused by passing-through current resulted from the crossover of gate driving signals of devices in the output stage circuit, thereby achieving a minimal transmission delay and low circuit noise while ensuring the reliability. The control circuit can adapt to different application environments and has high reliability.

For the deficiency in common mode noise processing of a high-voltage gate driving circuit, the gate driving circuit in this embodiment can resist noise interference, and reduce the impact of offset noise, so that the circuit works more reliably. Besides, the circuit has a simple structure, stable performance and strong adaptability.

An additional NMOS transistor is added to the signal shaping circuit, which improves requirements for the amplitude of an input differential signal. By setting parallel resistors and capacitors in the circuit, the amplitude of the input differential signal needs to be higher than a certain value for a certain period of time before being recognized as a trigger signal, and some interference or offset noise caused by device mismatch is effectively filtered out. A gate driving circuit using the signal shaping circuit further includes a pulse generating circuit, a level shift circuit, a noise filter circuit and an output stage driving circuit. The offset noise and common mode noise can be effectively filtered out through the cooperation of the circuits. By using the signal shaping circuit and the corresponding gate driving circuit of the present disclosure, a circuit works more reliably and the performance is more stable.

In the specification, the present disclosure has been described with reference to its specific embodiments. However, it is obvious that various modifications and changes can still be made without departing from the scope of the present disclosure. Therefore, the specification and accompanying drawings should be regarded as descriptive rather than restrictive.

## Claims

1. A signal shaping circuit, comprising a turn-on signal shaping module and a turn-off signal shaping module,
wherein the turn-on signal shaping module comprises a first PMOS transistor (MP1), a first NMOS transistor (MN1), a second NMOS transistor (MN2), first resistor (R1), a second resistor (R2), a first capacitor (C1), and a first inverter (INV1);
a gate of the first PMOS transistor is connected with a first input signal (Vput1), a drain of the first PMOS transistor is respectively connected with a first end of the first resistor, a first end of the first capacitor, and a gate of the second NMOS transistor, and a source of the first PMOS transistor is connected with a source of the first NMOS transistor;
a gate of the first NMOS transistor is connected with a second input signal (Vput2), and a drain of the first NMOS transistor and a first end of the second resistor are both connected with a reference voltage (VB);
a drain of the second NMOS transistor is connected with a second end of the second resistor, and a source of the second NMOS transistor, a second end of the first resistor, and a second end of the first capacitor are all grounded;
an input end of the first inverter is connected with the second end of the second resistor, a voltage end of the first inverter is connected with the reference voltage, a ground end of the first inverter is grounded, and an output end of the first inverter constitutes a first output end (A) of the signal shaping circuit;
the turn-off signal shaping module comprises a second PMOS transistor (MP2), a third NMOS transistor (MN3), a fourth NMOS transistor (MN4), a third resistor (R3), a fourth resistor (R4), a second capacitor (C2), and a second inverter (INV2);
a gate of the second PMOS transistor is connected with the second input signal, a drain of the second PMOS transistor is respectively connected with a first end of the third resistor, a first end of the second capacitor, and a gate of the fourth NMOS transistor, and a source of the second PMOS transistor is connected with a source of the third NMOS transistor;
a gate of the third NMOS transistor is connected with the first input signal, and a drain of the third NMOS transistor and a first end of the fourth resistor are both connected with the reference voltage;
a drain of the fourth NMOS transistor is connected with a second end of the fourth resistor, and a source of the fourth NMOS transistor, a second end of the third resistor, and a second end of the second capacitor are all grounded; and
an input end of the second inverter is connected with the second end of the fourth resistor, a voltage end of the second inverter is connected with the reference voltage, a ground end of the second inverter is grounded, and an output end of the second inverter constitutes a second output end (B) of the signal shaping circuit.

2. The signal shaping circuit according to claim 1, wherein
the turn-on signal shaping module further comprises a third PMOS transistor (MP3), a fifth NMOS transistor (MN5), a sixth NMOS transistor (MN6), and a fifth resistor (R5);
a gate of the third PMOS transistor is connected with the second input signal, and a drain of the third PMOS transistor is respectively connected with a drain and a gate of the fifth NMOS transistor and a gate of the sixth NMOS transistor; a source of the third PMOS transistor is connected with the reference voltage through the fifth resistor;
a source of the fifth NMOS transistor and a source of the sixth NMOS transistor are both grounded;
a drain of the sixth NMOS transistor is connected with a drain of the first PMOS transistor;
the turn-off signal shaping module further comprises a fourth PMOS transistor (MP4), a seventh NMOS transistor (MN7), an eighth NMOS transistor (MN8), and a sixth resistor (R6);
a gate of the fourth PMOS transistor is connected with the first input signal, and a drain of the fourth PMOS transistor is respectively connected with a drain and a gate of the seventh NMOS transistor and a gate of the eighth NMOS transistor; a source of the fourth PMOS transistor is connected with the reference voltage through the sixth resistor;
a source of the seventh NMOS transistor and a source of the eighth NMOS transistor are both grounded; and
a drain of the eighth NMOS transistor is connected with a drain of the second PMOS transistor.

3. A gate driving circuit comprising the signal shaping circuit described in claim 1 or 2, wherein the gate driving circuit further comprises:
a pulse generating circuit, configured to generate a pulse-on signal (Von) and a pulse-off signal (Voff) according to an input signal (Vi);
a level shift circuit, configured to convert the pulse-on signal and the pulse-off signal into the first input signal (Vput1) and the second input signal (Vput2) sent to the signal shaping circuit;
a noise filter circuit, configured to further eliminate short-pulse noise in a signal outputted by the signal shaping circuit; and
an output stage driving circuit, connected with the noise filter circuit.

4. The gate driving circuit according to claim 3, wherein the level shift circuit comprises a ninth NMOS transistor (MN9) and a tenth NMOS transistor (MN10),
wherein a gate of the ninth NMOS transistor is connected with the turn-on pulse signal, a source of the ninth NMOS transistor is grounded, and a drain of the ninth NMOS transistor is connected with the reference voltage through a seventh resistor (R7);
a drain of the ninth NMOS transistor is further served as a first output end of the level shift circuit to output the first input signal;
a gate of the tenth NMOS transistor is connected with the pulse-off signal, a source of the tenth NMOS transistor is grounded, and a drain of the tenth NMOS transistor is connected with the reference voltage through an eighth resistor (R8);
a drain of the tenth NMOS transistor is further served as a second output end of the level shift circuit to output the second input signal.

5. The gate driving circuit according to claim 4, wherein the level shift circuit further comprises a first Zener diode (Z1) and a second Zener diode (Z2);
an anode of the first Zener diode is connected with a drain of the ninth NMOS transistor, and a cathode of the first Zener diode is connected with the reference voltage; and
an anode of the second Zener diode is connected with a drain of the tenth NMOS transistor, and a cathode of the second Zener diode is connected with the reference voltage.

6. The gate driving circuit according to claim 3, wherein the noise filter circuit comprises a first inverter chain, a ninth resistor (R9), a third capacitor (C3), a first Schmitt trigger (SIMT1), a second inverter chain, a tenth resistor (R10), a fourth capacitor (C4), and a second Schmitt trigger (SIMT2);
an input end of the first inverter chain is connected with the first output end of the signal shaping circuit, an output end of the first inverter chain is connected with a first end of the ninth resistor, a second end of the ninth resistor is respectively connected with a first end of the third capacitor and an input end of the first Schmitt trigger, a second end of the third capacitor is grounded, and an output end of the first Schmitt trigger constitutes a first output end of the noise filter circuit, and is connected with a first input end of the output stage driving circuit;
an input end of the second inverter chain is connected with the second output end of the signal shaping circuit, an output end of the second inverter chain is connected with a first end of the tenth resistor, a second end of the tenth resistor is respectively connected with a first end of the fourth capacitor and an input end of the second Schmitt trigger, a second end of the fourth capacitor is grounded, and an output end of the second Schmitt trigger constitutes a second output end of the noise filter circuit, and is connected with a second input end of the output stage driving circuit;
power supply ends of the first inverter chain, the second inverter and the first Schmitt trigger are all connected with the reference voltage; and
ground ends of the first inverter chain, the second inverter and the first Schmitt trigger are all grounded.

7. The gate driving circuit according to claim 6, wherein the output stage driving circuit comprises a first NAND gate (NAND1), a third inverter chain, a fifth PMOS transistor (MP5), an eleventh resistor (R11), a second NAND gate (NAND2), a fourth inverter chain, an eleventh NMOS transistor (MN11), and a twelfth resistor (R12);
a first end of the first NAND gate constitutes a first input end of the output stage driving circuit, an output end of the first NAND gate is respectively connected with an input end of the third inverter chain and a second end of the second NAND gate, an output end of the third inverter chain is connected with a gate of the fifth PMOS transistor, a source of the fifth PMOS transistor is connected with the reference voltage, and a drain of the fifth PMOS transistor is connected with a first end of the eleventh resistor;
a first end of the second NAND gate constitutes a second input end of the output stage driving circuit, an output end of the second NAND gate is respectively connected with an input end of the fourth inverter chain and a second end of the first NAND gate, an output end of the fourth inverter chain is connected with a gate of the eleventh NMOS transistor, a source of the eleventh NMOS transistor is grounded, and a drain of the eleventh NMOS transistor is connected with a first end of the twelfth resistor;
a second end of the eleventh resistor and a second end of the twelfth resistor together constitute an output end (OUT) of the output stage driving circuit
power supply ends of the first NAND gate, the third inverter chain, the second NAND gate, and the fourth inverter chain are all connected with the reference voltage; and
ground ends of the first NAND gate, the third inverter chain, the second NAND gate, and the fourth inverter chain are all grounded.

8. The gate driving circuit according to claim 6, wherein the output stage driving circuit comprises a third NAND gate (NAND3), gate,a fourth NAND gate (NAND4), a fifth inverter chain, a sixth inverter chain, a twelfth NMOS transistor (MN12), a thirteenth NMOS transistor (MN13), a fourteenth NMOS transistor (MN14), a fifteenth NMOS transistor (MN15), a sixth PMOS transistor (MP6), a seventh PMOS transistor (MP7), an eighth PMOS transistor (MP8), and a ninth PMOS transistor (MP9);
a first end of the third NAND gate constitutes a first input end of the output stage driving circuit, and an output end of the third NAND gate is respectively connected with an input end of the fifth inverter chain and a second end of the fourth NAND gate;
a first end of the fourth NAND gate constitutes a second input end of the output stage driving circuit, and an output end of the fourth NAND gate is connected with a second end of the third NAND gate;
an output end of the fifth inverter chain is respectively connected with an input end of the sixth inverter chain, a gate of the seventh PMOS transistor, and a gate of the fourteenth NMOS transistor;
an output end of the sixth inverter chain is respectively connected with a drain of the twelfth NMOS transistor, a gate of the thirteenth NMOS transistor, a drain of the sixth PMOS transistor, and a gate of the eighth PMOS transistor;
a drain of the seventh PMOS transistor is respectively connected with a drain of the thirteenth NMOS transistor, a gate of the ninth PMOS transistor, and a gate of the sixth PMOS transistor;
a drain of the fourteenth NMOS transistor is respectively connected with a drain of the eighth PMOS transistor, a gate of the fifteenth NMOS transistor, and a gate of the twelfth NMOS transistor;
a source of the seventh PMOS transistor, a source of the eighth PMOS transistor, and a source of the ninth PMOS transistor are all connected with the reference voltage;
a source of the twelfth NMOS transistor, a source of the thirteenth NMOS transistor, a source of the fourteenth NMOS transistor, and a source of the fifteenth NMOS transistor are all grounded;
a drain of the ninth PMOS transistor and a drain of the fifteenth NMOS transistor together constitute an output end of the output stage driving circuit;
power supply ends of the third NAND gate, the fourth NAND gate, the fifth inverter chain, and the sixth inverter chain are all connected with the reference voltage; and
ground ends of the third NAND gate, the fourth NAND gate, the fifth inverter chain and the sixth inverter chain are all grounded.

## Patentansprüche

1. Signalformerschaltung, umfassend ein Einschaltsignal-Formungsmodul und ein Ausschaltsignal-Formungsmodul,
wobei das Einschaltsignal-Formungsmodul einen ersten PMOS-Transistor (MP1), einen ersten NMOS-Transistor (MN1), einen zweiten NMOS-Transistor (MN2), einen ersten Widerstand (R1), einen zweiten Widerstand (R2), einen ersten Kondensator (C1) und einen ersten Inverter (INV1) umfasst;
ein Gate des ersten PMOS-Transistors mit einem ersten Eingangssignal (Vput1) verbunden ist, ein Drain des ersten PMOS-Transistors jeweils mit einem ersten Ende des ersten Widerstands, einem ersten Ende des ersten Kondensators und einem Gate des zweiten NMOS-Transistors verbunden ist und eine Source des ersten PMOS-Transistors mit einer Source des ersten NMOS-Transistors verbunden ist;
ein Gate des ersten NMOS-Transistors mit einem zweiten Eingangssignal (Vput2) verbunden ist und ein Drain des ersten NMOS-Transistors und ein erstes Ende des zweiten Widerstands beide mit einer Referenzspannung (VB) verbunden sind;
ein Drain des zweiten NMOS-Transistors mit einem zweiten Ende des zweiten Widerstands verbunden ist und eine Source des zweiten NMOS-Transistors, ein zweites Ende des ersten Widerstands und ein zweites Ende des ersten Kondensators alle an Masse liegen;
ein Eingangsende des ersten Inverters mit dem zweiten Ende des zweiten Widerstands verbunden ist, ein Spannungsende des ersten Inverters mit der Referenzspannung verbunden ist, ein Masseende des ersten Inverters an Masse liegt und ein Ausgangsende des ersten Inverters ein erstes Ausgangsende (A) der Signalformerschaltung bildet;
das Ausschaltsignal-Formungsmodul einen zweiten PMOS-Transistor (MP2), einen dritten NMOS-Transistor (MN3), einen vierten NMOS-Transistor (MN4), einen dritten Widerstand (R3), einen vierten Widerstand (R4), einen zweiten Kondensator (C2) und einen zweiten Inverter (INV2) umfasst;
ein Gate des zweiten PMOS-Transistors mit dem zweiten Eingangssignal verbunden ist, ein Drain des zweiten PMOS-Transistors jeweils mit einem ersten Ende des dritten Widerstands, einem ersten Ende des zweiten Kondensators und einem Gate des vierten NMOS-Transistors verbunden ist und eine Source des zweiten PMOS-Transistors mit einer Source des dritten NMOS-Transistors verbunden ist;
ein Gate des dritten NMOS-Transistors mit dem ersten Eingangssignal verbunden ist und ein Drain des dritten NMOS-Transistors und ein erstes Ende des vierten Widerstands beide mit der Referenzspannung verbunden sind;
ein Drain des vierten NMOS-Transistors mit einem zweiten Ende des vierten Widerstands verbunden ist und eine Source des vierten NMOS-Transistors, ein zweites Ende des dritten Widerstands und ein zweites Ende des zweiten Kondensators alle an Masse liegen; und
ein Eingangsende des zweiten Inverters mit dem zweiten Ende des vierten Widerstands verbunden ist, ein Spannungsende des zweiten Inverters mit der Referenzspannung verbunden ist, ein Masseende des zweiten Inverters an Masse liegt und ein Ausgangsende des zweiten Inverters ein zweites Ausgangsende (B) der Signalformerschaltung bildet.

2. Signalformerschaltung nach Anspruch 1, wobei
das Einschaltsignal-Formungsmodul ferner einen dritten PMOS-Transistor (MP3), einen fünften NMOS-Transistor (MN5), einen sechsten NMOS-Transistor (MN6) und einen fünften Widerstand (R5) umfasst;
ein Gate des dritten PMOS-Transistors mit dem zweiten Eingangssignal verbunden ist und ein Drain des dritten PMOS-Transistors jeweils mit einem Drain und einem Gate des fünften NMOS-Transistors und einem Gate des sechsten NMOS-Transistors verbunden ist; eine Source des dritten PMOS-Transistors über den fünften Widerstand mit der Referenzspannung verbunden ist;
eine Source des fünften NMOS-Transistors und eine Source des sechsten NMOS-Transistors beide an Masse liegen;
ein Drain des sechsten NMOS-Transistors mit einem Drain des ersten PMOS-Transistors verbunden ist;
das Ausschaltsignal-Formungsmodul ferner einen vierten PMOS-Transistor (MP4), einen siebenten NMOS-Transistor (MN7), einen achten NMOS-Transistor (MN8) und einen sechsten Widerstand (R6) umfasst;
ein Gate des vierten PMOS-Transistors mit dem ersten Eingangssignal verbunden ist und ein Drain des vierten PMOS-Transistors jeweils mit einem Drain und einem Gate des siebenten NMOS-Transistors und einem Gate des achten NMOS-Transistors verbunden ist; eine Source des vierten PMOS-Transistors über den sechsten Widerstand mit der Referenzspannung verbunden ist;
eine Source des siebenten NMOS-Transistors und eine Source des achten NMOS-Transistors beide an Masse liegen; und
ein Drain des achten NMOS-Transistors mit einem Drain des zweiten PMOS-Transistors verbunden ist.

3. Gate-Ansteuerschaltung, umfassend die in Anspruch 1 oder 2 beschriebene Signalformerschaltung, wobei die Gate-Ansteuerschaltung ferner umfasst:
eine Impulserzeugungsschaltung, ausgelegt, ein Impuls-Einschaltsignal (Von) und ein Impuls-Ausschaltsignal (Voff) gemäß einem Eingangssignal (Vi) zu erzeugen;
eine Pegelverschiebungsschaltung, ausgelegt, das Impuls-Einschaltsignal und das Impuls-Ausschaltsignal in das erste Eingangssignal (Vput1) und das zweite Eingangssignal (Vput2) umzuwandeln, die an die Signalformerschaltung gesendet werden;
eine Störungsfilterschaltung, ausgelegt, Kurzimpulsstörungen in einem durch die Signalformerschaltung ausgegebenen Signal weiter zu beseitigen; und
eine Ausgangsstufenansteuerschaltung, verbunden mit der Störungsfilterschaltung.

4. Gate-Ansteuerschaltung nach Anspruch 3, wobei die Pegelverschiebungsschaltung einen neunten NMOS-Transistor (MN9) und einen zehnten NMOS-Transistor (MN10) umfasst,
wobei ein Gate des neunten NMOS-Transistors mit dem Impuls-Einschaltsignal verbunden ist, eine Source des neunten NMOS-Transistors an Masse liegt und ein Drain des neunten NMOS-Transistors über einen siebenten Widerstand (R7) mit der Referenzspannung verbunden ist;
ein Drain des neunten NMOS-Transistors ferner als ein erstes Ausgangsende der Pegelverschiebungsschaltung dient, um das erste Eingangssignal auszugeben;
ein Gate des zehnten NMOS-Transistors mit dem Impuls-Ausschaltsignal verbunden ist, eine Source des zehnten NMOS-Transistors an Masse liegt und ein Drain des zehnten NMOS-Transistors über einen achten Widerstand (R8) mit der Referenzspannung verbunden ist;
ein Drain des zehnten NMOS-Transistors ferner als ein zweites Ausgangsende der Pegelverschiebungsschaltung dient, um das zweite Eingangssignal auszugeben.

5. Gate-Ansteuerschaltung nach Anspruch 4, wobei die Pegelverschiebungsschaltung ferner eine erste Z-Diode (Z1) und eine zweite Z-Diode (Z2) umfasst;
eine Anode der ersten Z-Diode mit einem Drain des neunten NMOS-Transistors verbunden ist und eine Kathode der ersten Z-Diode mit der Referenzspannung verbunden ist; und
eine Anode der zweiten Z-Diode mit einem Drain des zehnten NMOS-Transistors verbunden ist und eine Kathode der zweiten Z-Diode mit der Referenzspannung verbunden ist.

6. Gate-Ansteuerschaltung nach Anspruch 3, wobei die Störungsfilterschaltung eine erste Inverterkette, einen neunten Widerstand (R9), einen dritten Kondensator (C3), einen ersten Schmitt-Trigger (SIMT1), eine zweite Inverterkette, einen zehnten Widerstand (R10), einen vierten Kondensator (C4) und einen zweiten Schmitt-Trigger (SIMT2) umfasst;
ein Eingangsende der ersten Inverterkette mit dem ersten Ausgangsende der Signalformerschaltung verbunden ist, ein Ausgangsende der ersten Inverterkette mit einem ersten Ende des neunten Widerstands verbunden ist, ein zweites Ende des neunten Widerstands jeweils mit einem ersten Ende des dritten Kondensators und einem Eingangsende des ersten Schmitt-Triggers verbunden ist, ein zweites Ende des dritten Kondensators an Masse liegt und ein Ausgangsende des ersten Schmitt-Triggers ein erstes Ausgangsende der Störungsfilterschaltung bildet und mit einem ersten Eingangsende der Ausgangsstufenansteuerschaltung verbunden ist;
ein Eingangsende der zweiten Inverterkette mit dem zweiten Ausgangsende der Signalformerschaltung verbunden ist, ein Ausgangsende der zweiten Inverterkette mit einem ersten Ende des zehnten Widerstands verbunden ist, ein zweites Ende des zehnten Widerstands jeweils mit einem ersten Ende des vierten Kondensators und einem Eingangsende des zweiten Schmitt-Triggers verbunden ist, ein zweites Ende des vierten Kondensators an Masse liegt und ein Ausgangsende des zweiten Schmitt-Triggers ein zweites Ausgangsende der Störungsfilterschaltung bildet und mit einem zweiten Eingangsende der Ausgangsstufenansteuerschaltung verbunden ist;
Stromversorgungsenden der ersten Inverterkette, des zweiten Inverters und des ersten Schmitt-Triggers alle mit der Referenzspannung verbunden sind; und
Masseenden der ersten Inverterkette, des zweiten Inverters und des ersten Schmitt-Triggers alle an Masse liegen.

7. Gate-Ansteuerschaltung nach Anspruch 6, wobei die Ausgangsstufenansteuerschaltung ein erstes NAND-Gate (NAND1), eine dritte Inverterkette, einen fünften PMOS-Transistor (MP5), einen elften Widerstand (R11), ein zweites NAND-Gate (NAND2), eine vierte Inverterkette, einen elften NMOS-Transistor (MN11) und einen zwölften Widerstand (R12) umfasst;
ein erstes Ende des ersten NAND-Gates ein erstes Eingangsende der Ausgangsstufenansteuerschaltung bildet, ein Ausgangsende des ersten NAND-Gate jeweils mit einem Eingangsende der dritten Inverterkette und einem zweiten Ende des zweiten NAND-Gate verbunden ist, ein Ausgangsende der dritten Inverterkette mit einem Gate des fünften PMOS-Transistors verbunden ist, eine Source des fünften PMOS-Transistors mit der Referenzspannung verbunden ist und ein Drain des fünften PMOS-Transistors mit einem ersten Ende des elften Widerstands verbunden ist;
ein erstes Ende des zweiten NAND-Gates ein zweites Eingangsende der Ausgangsstufenansteuerschaltung bildet, ein Ausgangsende des zweiten NAND-Gate jeweils mit einem Eingangsende der vierten Inverterkette und einem zweiten Ende des ersten NAND-Gates verbunden ist, ein Ausgangsende der vierten Inverterkette mit einem Gate des elften NMOS-Transistors verbunden ist, eine Source des elften NMOS-Transistors an Masse liegt und ein Drain des elften NMOS-Transistors mit einem ersten Ende des zwölften Widerstands verbunden ist;
ein zweites Ende des elften Widerstands und ein zweites Ende des zwölften Widerstands zusammen ein Ausgangsende (OUT) der Ausgangsstufenansteuerschaltung bilden;
Stromversorgungsenden des ersten NAND-Gates, der dritten Inverterkette, des zweiten NAND-Gates und der vierten Inverterkette alle mit der Referenzspannung verbunden sind; und
Masseenden des ersten NAND-Gates, der dritten Inverterkette, des zweiten NAND-Gates und der vierten Inverterkette alle an Masse liegen.

8. Gate-Ansteuerschaltung nach Anspruch 6, wobei die Ausgangsstufenansteuerschaltung ein drittes NAND-Gates (NAND3), ein viertes NAND-Gates (NAND4), eine fünfte Inverterkette, eine sechste Inverterkette, einen zwölften NMOS-Transistor (MN12), einen dreizehnten NMOS-Transistor (MN13), einen vierzehnten NMOS-Transistor (MN14), einen fünfzehnten NMOS-Transistor (MN15), einen sechsten PMOS-Transistor (MP6), einen siebenten PMOS-Transistor (MP7), einen achten PMOS-Transistor (MP8) und einen neunten PMOS-Transistor (MP9) umfasst;
ein erstes Ende des dritten NAND-Gates ein erstes Eingangsende der Ausgangsstufenansteuerschaltung bildet und ein Ausgangsende des dritten NAND-Gates jeweils mit einem Eingangsende der fünften Inverterkette und einem zweiten Ende des vierten NAND-Gates verbunden ist;
ein erstes Ende des vierten NAND-Gates ein zweites Eingangsende der Ausgangsstufenansteuerschaltung bildet und ein Ausgangsende des vierten NAND-Gates mit einem zweiten Ende des dritten NAND-Gates verbunden ist;
ein Ausgangsende der fünften Inverterkette jeweils mit einem Eingangsende der sechsten Inverterkette, einem Gate des siebenten PMOS-Transistors und einem Gate des vierzehnten NMOS-Transistors verbunden ist;
ein Ausgangsende der sechsten Inverterkette jeweils mit einem Drain des zwölften NMOS-Transistors, einem Gate des dreizehnten NMOS-Transistors, einem Drain des sechsten PMOS-Transistors und einem Gate des achten PMOS-Transistors verbunden ist;
ein Drain des siebenten PMOS-Transistors jeweils mit einem Drain des dreizehnten NMOS-Transistors, einem Gate des neunten PMOS-Transistors und einem Gate des sechsten PMOS-Transistors verbunden ist;
ein Drain des vierzehnten NMOS-Transistors jeweils mit einem Drain des achten PMOS-Transistors, einem Gate des fünfzehnten NMOS-Transistors und einem Gate des zwölften NMOS-Transistors verbunden ist;
eine Source des siebenten PMOS-Transistors, eine Source des achten PMOS-Transistors und eine Source des neunten PMOS-Transistors alle mit der Referenzspannung verbunden sind;
eine Source des zwölften NMOS-Transistors, eine Source des dreizehnten NMOS-Transistors, eine Source des vierzehnten NMOS-Transistors und eine Source des fünfzehnten NMOS-Transistors alle an Masse liegen;
ein Drain des neunten PMOS-Transistors und ein Drain des fünfzehnten NMOS-Transistors zusammen ein Ausgangsende der Ausgangsstufenansteuerschaltung bilden;
Stromversorgungsenden des dritten NAND-Gates, des vierten NAND-Gates, der fünften Inverterkette und der sechsten Inverterkette alle mit der Referenzspannung verbunden sind; und
Masseenden des dritten NAND-Gates, des vierten NAND-Gates, der fünften Inverterkette und der sechsten Inverterkette alle an Masse liegen.

## Revendications

1. Circuit de mise en forme de signaux, comprenant un module de mise en forme de signaux d'allumage et un module de mise en forme de signaux d'extinction,
dans lequel le module de mise en forme de signaux d'allumage comprend un premier transistor PMOS (MP1), un premier transistor NMOS (MN1), un deuxième transistor NMOS (MN2), une première résistance (R1), une deuxième résistance (R2), un premier condensateur (C1) et un premier onduleur (INV1) ;
une grille du premier transistor PMOS est connectée à un premier signal d'entrée (Vput1), un drain du premier transistor PMOS est respectivement connecté à une première extrémité de la première résistance, à une première extrémité du premier condensateur et à une grille du deuxième transistor NMOS, et une source du premier transistor PMOS est connectée à une source du premier transistor NMOS ;
une grille du premier transistor NMOS est connectée à un deuxième signal d'entrée (Vput2), et un drain du premier transistor NMOS et une première extrémité de la deuxième résistance sont tous deux connectés à une tension de référence (VB) ;
un drain du deuxième transistor NMOS est connecté à une deuxième extrémité de la deuxième résistance, et une source du deuxième transistor NMOS, une deuxième extrémité de la première résistance et une deuxième extrémité du premier condensateur sont toutes mises à la masse ;
une extrémité d'entrée du premier onduleur est connectée à la deuxième extrémité de la deuxième résistance, une extrémité de tension du premier onduleur est connectée à la tension de référence, une extrémité de masse du premier onduleur est mise à la masse, et une extrémité de sortie du premier onduleur constitue une première extrémité de sortie (A) du circuit de mise en forme de signaux ;
le module de mise en forme de signaux d'extinction comprend un deuxième transistor PMOS (MP2), un troisième transistor NMOS (MN3), un quatrième transistor NMOS (MN4), une troisième résistance (R3), une quatrième résistance (R4), un deuxième condensateur (C2) et un deuxième onduleur (INV2) ;
une grille du deuxième transistor PMOS est connectée au deuxième signal d'entrée, un drain du deuxième transistor PMOS est respectivement connecté à une première extrémité de la troisième résistance, à une première extrémité du deuxième condensateur et à une grille du quatrième transistor NMOS, et une source du deuxième transistor PMOS est connectée à une source du troisième transistor NMOS ;
une grille du troisième transistor NMOS est connectée au premier signal d'entrée et un drain du troisième transistor NMOS et une première extrémité de la quatrième résistance sont tous deux connectés à la tension de référence ;
un drain du quatrième transistor NMOS est connecté à une deuxième extrémité de la quatrième résistance, et une source du quatrième transistor NMOS, une deuxième extrémité de la troisième résistance et une deuxième extrémité du deuxième condensateur sont toutes mises à la masse ; et
une extrémité d'entrée du deuxième onduleur est connectée à la deuxième extrémité de la quatrième résistance, une extrémité de tension du deuxième onduleur est connectée à la tension de référence, une extrémité de masse du deuxième onduleur est mise à la masse, et une extrémité de sortie du deuxième onduleur constitue une deuxième extrémité de sortie (B) du circuit de mise en forme de signaux.

2. Circuit de mise en forme de signaux selon la revendication 1, dans lequel
le module de mise en forme de signaux d'allumage comprend en outre un troisième transistor PMOS (MP3), un cinquième transistor NMOS (MN5), un sixième transistor NMOS (MN6) et une cinquième résistance (R5) ;
une grille du troisième transistor PMOS est connectée au deuxième signal d'entrée, et un drain du troisième transistor PMOS est respectivement connecté à un drain et à une grille du cinquième transistor NMOS et à une grille du sixième transistor NMOS ; une source du troisième transistor PMOS est connectée à la tension de référence via la cinquième résistance ;
une source du cinquième transistor NMOS et une source du sixième transistor NMOS sont toutes deux mises à la masse ;
un drain du sixième transistor NMOS est connecté à un drain du premier transistor PMOS ;
le module de mise en forme de signaux d'extinction comprend en outre un quatrième transistor PMOS (MP4), un septième transistor NMOS (MN7), un huitième transistor NMOS (MN8) et une sixième résistance (R6) ;
une grille du quatrième transistor PMOS est connectée au premier signal d'entrée, et un drain du quatrième transistor PMOS est respectivement connecté à un drain et à une grille du septième transistor NMOS et à une grille du huitième transistor NMOS ; une source du quatrième transistor PMOS est connectée à la tension de référence via la sixième résistance ;
une source du septième transistor NMOS et une source du huitième transistor NMOS sont toutes deux mises à la masse ; et
un drain du huitième transistor NMOS est connecté à un drain du deuxième transistor PMOS.

3. Circuit de commande de grille comprenant le circuit de mise en forme de signaux décrit dans la revendication 1 ou 2, dans lequel le circuit de commande de grille comprend en outre :
un circuit générateur d'impulsions, configuré pour générer un signal d'activation d'impulsions (Von) et un signal de désactivation d'impulsions (Voff) en fonction d'un signal d'entrée (Vi) ;
un circuit de décalage de niveau, configuré pour convertir le signal d'activation d'impulsions et le signal de désactivation d'impulsions en le premier signal d'entrée (Vput1) et le deuxième signal d'entrée (Vput2) envoyés au circuit de mise en forme de signaux ;
un circuit de filtre de bruit, configuré pour éliminer davantage le bruit à courtes impulsions dans un signal émis par le circuit de mise en forme de signaux ; et
un circuit de commande d'étage de sortie, connecté au circuit de filtre de bruit.

4. Circuit de commande de grille selon la revendication 3, dans lequel le circuit de décalage de niveau comprend un neuvième transistor NMOS (MN9) et un dixième transistor NMOS (MN10),
dans lequel une grille du neuvième transistor NMOS est connectée au signal d'impulsion d'activation, une source du neuvième transistor NMOS est mise à la masse et un drain du neuvième transistor NMOS est connecté à la tension de référence via une septième résistance (R7) ;
un drain du neuvième transistor NMOS est en outre utilisé comme une première extrémité de sortie du circuit de décalage de niveau pour émettre le premier signal d'entrée ;
une grille du dixième transistor NMOS est connectée au signal d'impulsion de désactivation, une source du dixième transistor NMOS est mise à la masse et un drain du dixième transistor NMOS est connecté à la tension de référence via une huitième résistance (R8) ;
un drain du dixième transistor NMOS est en outre utilisé comme une deuxième extrémité de sortie du circuit de décalage de niveau pour émettre le deuxième signal d'entrée ;

5. Circuit de commande de grille selon la revendication 4, dans lequel le circuit de décalage de niveau comprend en outre une première diode Zener (Z1) et une deuxième diode Zener (Z2) ;
une anode de la première diode Zener est connectée à un drain du neuvième transistor NMOS, et une cathode de la première diode Zener est connectée à la tension de référence ; et
une anode de la deuxième diode Zener est connectée à un drain du dixième transistor NMOS, et une cathode de la deuxième diode Zener est connectée à la tension de référence.

6. Circuit de commande de grille selon la revendication 3, dans lequel le circuit de filtre de bruit comprend une première chaîne d'onduleurs, une neuvième résistance (R9), un troisième condensateur (C3), une première bascule de Schmitt (SIMT1), une deuxième chaîne d'onduleurs, une dixième résistance (R10), un quatrième condensateur (C4) et une deuxième bascule de Schmitt (SIMT2) ;
une extrémité d'entrée de la première chaîne d'onduleurs est connectée à la première extrémité de sortie du circuit de mise en forme de signaux, une extrémité de sortie de la première chaîne d'onduleurs est connectée à une première extrémité de la neuvième résistance, une deuxième extrémité de la neuvième résistance est respectivement connectée à une première extrémité du troisième condensateur et à une extrémité d'entrée de la première bascule de Schmitt, une deuxième extrémité du troisième condensateur est mise à la masse, et une extrémité de sortie de la première bascule de Schmitt constitue une première extrémité de sortie du circuit de filtre de bruit, et est connectée à une première extrémité d'entrée du circuit de commande d'étage de sortie ;
une extrémité d'entrée de la deuxième chaîne d'onduleurs est connectée à la deuxième extrémité de sortie du circuit de mise en forme de signaux, une extrémité de sortie de la deuxième chaîne d'onduleurs est connectée à une première extrémité de la dixième résistance, une deuxième extrémité de la dixième résistance est respectivement connectée à une première extrémité du quatrième condensateur et à une extrémité d'entrée de la deuxième bascule de Schmitt, une deuxième extrémité du quatrième condensateur est mise à la masse, et une extrémité de sortie de la deuxième bascule de Schmitt constitue une deuxième extrémité de sortie du circuit de filtre de bruit, et est connectée à une deuxième extrémité d'entrée du circuit de commande d'étage de sortie ;
les extrémités d'alimentation électrique de la première chaîne d'onduleurs, du deuxième onduleur et de la première bascule de Schmitt sont toutes connectées à la tension de référence ; et
les extrémités à la masse de la première chaîne d'onduleurs, du deuxième onduleur et de la première bascule de Schmitt sont toutes mises à la masse.

7. Circuit de commande de grille selon la revendication 6, dans lequel le circuit de commande d'étage de sortie comprend une première porte NON-ET (NAND1), une troisième chaîne d'onduleurs, un cinquième transistor PMOS (MP5), une onzième résistance (R11), une deuxième porte NON-ET (NAND2), une quatrième chaîne d'onduleurs, un onzième transistor NMOS (MN11), et une douzième résistance (R12) ;
une première extrémité de la première porte NON-ET constitue une première extrémité d'entrée du circuit de commande d'étage de sortie, une extrémité de sortie de la première porte NON-ET est respectivement connectée à une extrémité d'entrée de la troisième chaîne d'onduleurs et à une deuxième extrémité de la deuxième porte NON-ET, une extrémité de sortie de la troisième chaîne d'onduleurs est connectée à une grille du cinquième transistor PMOS, une source du cinquième transistor PMOS est connectée à la tension de référence, et un drain du cinquième transistor PMOS est connecté à une première extrémité de la onzième résistance ;
une première extrémité de la deuxième porte NON-ET constitue une deuxième extrémité d'entrée du circuit de commande d'étage de sortie, une extrémité de sortie de la deuxième porte NON-ET est respectivement connectée à une extrémité d'entrée de la quatrième chaîne d'onduleurs et à une deuxième extrémité de la première porte NON-ET, une extrémité de sortie de la quatrième chaîne d'onduleurs est connectée à une grille du onzième transistor NMOS, une source du onzième transistor NMOS est mise à la masse, et un drain du onzième transistor NMOS est connecté à une première extrémité de la douzième résistance ;
une deuxième extrémité de la onzième résistance et une deuxième extrémité de la douzième résistance constituent ensemble une extrémité de sortie (OUT) du circuit de commande d'étage de sortie ;
les extrémités d'alimentation électrique de la première porte NON-ET, de la troisième chaîne d'onduleurs, de la deuxième porte NON-ET et de la quatrième chaîne d'onduleurs sont toutes connectées à la tension de référence ; et
les extrémités à la masse de la première porte NON-ET, de la troisième chaîne d'onduleurs, de la deuxième porte NON-ET et de la quatrième chaîne d'onduleurs sont toutes mises à la masse.

8. Circuit de commande de grille selon la revendication 6, dans lequel le circuit de commande d'étage de sortie comprend une troisième porte NON-ET (NAND3), une quatrième porte NON-ET (NAND4), une cinquième chaîne d'onduleurs, une sixième chaîne d'onduleurs, un douzième transistor NMOS (MN12), un treizième transistor NMOS (MN13), un quatorzième transistor NMOS (MN14), un quinzième transistor NMOS (MN15), un sixième transistor PMOS (MP6), un septième transistor PMOS (MP7), un huitième transistor PMOS (MP8) et un neuvième transistor PMOS (MP9) ;
une première extrémité de la troisième porte NON-ET constitue une première extrémité d'entrée du circuit de commande d'étage de sortie, une extrémité de sortie de la troisième porte NON-ET est respectivement connectée à une extrémité d'entrée de la cinquième chaîne d'onduleurs et à une deuxième extrémité de la quatrième porte NON-ET ;
une première extrémité de la quatrième porte NON-ET constitue une deuxième extrémité d'entrée du circuit de commande d'étage de sortie, et une extrémité de sortie de la quatrième porte NON-ET est connectée à une deuxième extrémité de la troisième porte NON-ET ;
une extrémité de sortie de la cinquième chaîne d'onduleurs est connectée respectivement à une extrémité d'entrée de la sixième chaîne d'onduleurs, à une grille du septième transistor PMOS et à une grille du quatorzième transistor NMOS ;
une extrémité de sortie de la sixième chaîne d'onduleurs est respectivement connectée à un drain du douzième transistor NMOS, à une grille du treizième transistor NMOS, à un drain du sixième transistor PMOS et à une grille du huitième transistor PMOS ;
un drain du septième transistor PMOS est respectivement connecté à un drain du treizième transistor NMOS, à une grille du neuvième transistor PMOS et à une grille du sixième transistor PMOS ;
un drain du quatorzième transistor NMOS est respectivement connecté à un drain du huitième transistor PMOS, à une grille du quinzième transistor NMOS et à une grille du douzième transistor NMOS ;
une source du septième transistor PMOS, une source du huitième transistor PMOS et une source du neuvième transistor PMOS sont toutes connectées à la tension de référence ;
une source du douzième transistor NMOS, une source du treizième transistor NMOS, une source du quatorzième transistor NMOS et une source du quinzième transistor NMOS sont toutes mises à la masse ;
un drain du neuvième transistor PMOS et un drain du quinzième transistor NMOS constituent ensemble une extrémité de sortie du circuit de commande d'étage de sortie ;
les extrémités d'alimentation électrique de la troisième porte NON-ET, de la quatrième porte NON-ET, de la cinquième chaîne d'onduleurs et de la sixième chaîne d'onduleurs sont toutes connectées à la tension de référence ; et
les extrémités à la masse de la troisième porte NON-ET, de la quatrième porte NON-ET, de la cinquième chaîne d'onduleurs et de la sixième chaîne d'onduleurs sont toutes mises à la masse.
